# EUROPÄISCHE PATENTSCHRIFT

(11) **EP 2 734 602 B1**
(45) Veröffentlichungstag und Bekanntmachung des Hinweises auf die Patenterteilung: **01.02.2017**
(21) Anmeldenummer: 12826597.2
(22) Anmeldetag: 30.11.2012
(51) Int. Cl.: C09K 11/02, C09K 11/06, C09D 11/50, C09D 11/52, B42D 25/29

(54) **ELEKTROOPTISCHES SICHERHEITSELEMENT**
ELECTRO-OPTICAL SECURITY ELEMENT
ÉLÉMENT DE SÉCURITÉ ÉLECTRO-OPTIQUE

(30) Priorität: 01.12.2011 DE 102011119821
(43) Veröffentlichungstag der Anmeldung: 28.05.2014
(73) Patentinhaber: Bundesdruckerei GmbH, 10958 Berlin (DE)
(72) Erfinder: FISCHER, Jörg, 13053 Berlin (DE); PAESCHKE, Manfred, 16348 Wandlitz OT Basdorf (DE); MUTH, Oliver, 12277 Berlin (DE); MATHEA, Arthur, 14199 Berlin (DE)
(74) Vertreter: Jungblut & Seuss
(86) Internationale Anmeldenummer: PCT/DE2012/001196
(87) Internationale Veröffentlichungsnummer: WO 2013/079056

(56) Entgegenhaltungen:
- WO-A1-2005/115766
- WO-A2-2010/006583
- DE-A1-102008 034 021
- US-A1- 2005 103 424
- US-A1- 2011 269 065

## Beschreibung

Die Erfindung betrifft ein Sicherheitselement, insbesondere für ein Sicherheits- und/oder Wertdokument, enthaltend eine Matrix auf Basis eines organischen Polymerwerkstoffes, zumindest ein in der Matrix verteiltes elektrisch leitfähiges Pigment, und zumindest eine in der Matrix verteilte Leuchtsubstanz, welche in Gegenwart des leitfähigen Pigments zur kontaktlosen Anregung von Lichtemission befähigt ist, und, eine druckfähige Zubereitung zur Herstellung eines solchen Sicherheitselements, ein Sicherheit- und/oder Wertdokument mit einem solchen Sicherheitselement, sowie Verfahren zur Herstellung und Verifizierung eines solchen Sicherheit- und/oder Wertdokuments.

### Hintergrund der Erfindung und Stand der Technik

Sicherheits- und/oder Wertdokumente, Personalausweise, Reisepässe, ID-Karten, Zugangskontrollausweise, Visa, Steuerzeichen, Tickets, Führerscheine, Kraftfahrzeugpapiere, Banknoten, Schecks, Postwertzeichen, Kreditkarten, beliebige Chipkarten und Haftetiketten (z.B. zur Produktsicherung), weisen mitunter zumindest ein Substrat und eine meist in Teilbereichen oder vollständig transparente Deckschicht auf. Substrat und Deckschicht können ihrerseits aus einer Mehrzahl von Schichten bestehen. Zur Erschwerung von Fälschungen solcher Dokumente werden diese mit Sicherheitselementen ausgestattet. Beispielsweise Banknoten oder Briefmarken können aber auch nur aus einem Substrat bzw. einer Substratschicht bestehen, auf welche dann Sicherheitselemente beispielsweise in Form einer Druckfarbe aufgebracht sein können. Manche Sicherheitselemente umfassen unter bestimmten physikalischen Bedingungen lumineszierende Substanzen, wobei durch Inaugenscheinnahme oder maschinelle Erfassung der Lumineszenz unter diesen Bedingungen eine Verifizierung erfolgen kann.

Sicherheitselemente der eingangs genannten Art sind beispielsweise bekannt aus den Literaturstellen WO 2005/115766 A1, oder WO 2010/006583. Hierbei ist kommen partikuläre luminszierende Substanzen zum Einsatz, welche verkapselt sein können, i.e. eine Mantel-/Kernstruktur aufweisen. Diese Mantel-/Kernstrukturen sind in einer polymeren Matrix eingebettet. Generell liegen die Substanzen mit elektrolumineszierenden Eigenschaften stets in partikulärer Form vor, mit Teilchengrößen oberhalb 200 nm.

Nachteilig bei den insofern bekannten Sicherheitselementen ist die relativ niedrige erzielbar Lumineszenz unter vorgegebenen Anregungsbedingungen sowie der hohe Aufwand der Herstellung von Mantel-Kernstrukturen.

Aus der Literaturstelle EP 0688839 A2 sind Polycarbonate auf Basis eines geminal disubstituierten Dihydroxydiphenylcycloalkans per se bekannt. In diesem Stand der Technik werden solche Polycarbonate als Bindemittel von Siebdruckfarben eingesetzt. Dieser Literaturstelle sind auch Verfahren zur Herstellung solcher Polycarbonate entnehmbar.

Aus der Literaturstelle US 2011/026065 A1 sind organische Leuchtsubstanzen bekannt, wobei die organischen Moleküle mit einem Wax gekoppelt sind.

### Technisches Problem der Erfindung

Der Erfindung liegt daher das technische Problem zu Grunde, ein Sicherheitselement anzugeben, welches mit vergleichsweise geringem Aufwand herstellbar ist und in Hinblick auf die beobachtbare und/oder messbare Lumineszenz unter Anregungsbedingungen allen Anforderungen genügt und auch weitere Vorteile aufweisen kann, insbesondere eine erhöhte Vielfalt bei der Auswahl von strahlungsabgebenden Substanzen (UV, VIS, IR) und/oder eine erhöhte Sicherheit gegen Fälschungen aufweisen.

### Grundzüge der Erfindung und bevorzugte Ausführungsformen

Zur Lösung dieses technischen Problems lehrt die Erfindung ein vorzugsweise maschinenlesbares bzw. -detektierbares Sicherheitselement für ein Sicherheits- und/oder Wertdokument gemäss Anspruch 1.

Der Begriff "in Gegenwart" meint, dass die Leuchtsubstanz jedenfalls dann kontaktlos zur Emission angeregt werden kann, wenn das Leitpigment neben der Leuchtsubstanz ebenfalls in der Matrix in hinreichender Menge vorliegt.

Der organische Polymerwerkstoff kann grundsätzlich ein beliebiger im Bereich der Sicherheits-und/oder Wertdokumente verwendeter Polymerwerkstoff sein. Beispiele hierfür sind: transparente, opake oder undurchsichtige Polymerwerkstoffe, wie beispielsweise PC (Polycarbonat, insbesondere Bisphenol A Polycarbonat), PET (Polyethylenglykolterephthalat), PMMA (Polymethylmethacrylat), TPU (Thermoplastische Polyurethan Elastomere), PE (Polyethylen), PP (Polypropylen), PI (Polyimid oder Poly-trans-Isopren), PVC (Polyvinylchlorid), Polystyrol, Polyacrylate und Methacrylate, Vinylester, ABS und Copolymere solcher Polymere. Vorzugsweise handelt es sich um ein Polycarbonatderivat, insbesondere auf Basis Bisphenol A, vorzugsweise auf Basis eines geminal disubstituierten Dihydroxydiphenyl-cycloalkans.

Bevorzugt ist es, wenn das Polymer, beispielsweise das Polycarbonatderivat, ein mittleres Molekulargewicht (Gewichtsmittel) von mindestens 10.000, vorzugsweise von 20.000 bis 300.000, aufweist.

Im Einzelnen kann das Polycarbonatderivat funktionelle Carbonatstruktureinheiten der Formel (I) enthalten, 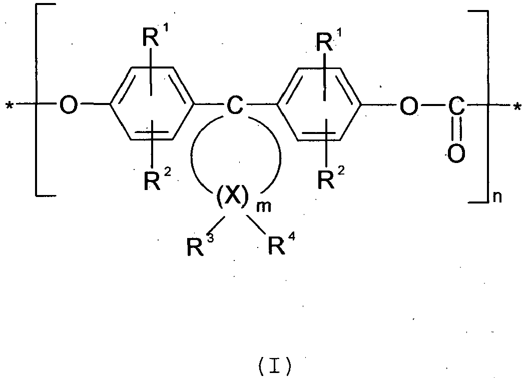 worin R¹ und R² unabhängig voneinander Wasserstoff, Halogen, bevorzugt Chlor oder Brom, C₁-C₈-Alkyl, C₅-C₆-Cycloalkyl, C₆-C₁₀-Aryl, bevorzugt Phenyl, und C₇-C₁₂-Aralkyl, bevorzugt Phenyl-C₁-C₄-Alkyl, insbesondere Benzyl; m eine ganze Zahl von 4 bis 7, bevorzugt 4 oder 5; R³ und R⁴ für jedes X individuell wählbar, unabhängig voneinander Wasserstoff oder C₁-C₆-Alkyl; X Kohlenstoff und n eine ganze Zahl größer 20 bedeuten, mit der Massgabe, dass an mindestens einem Atom X, R³ und R⁴ gleichzeitig Alkyl bedeuten.

Weiterhin bevorzugt ist es, wenn an 1 bis 2 Atomen X, insbesondere nur an einem Atom X, R³ und R⁴ gleichzeitig Alkyl sind. R³ und R⁴ können insbesondere Methyl sein. Die X-Atome in alpha-Stellung zu dem Diphenyl-substituierten C-Atom (C1) können nicht dialkylsubstituiert sein. Die X-Atome in beta-Stellung zu C1 können mit Alkyl disubstituiert sein. Bevorzugt ist m = 4 oder 5. Das Polycarbonatderivat kann beispielsweise auf Basis von Monmeren, wie 4,4'-(3,3,5-trimethylcyclohexan-1,1-diyl)diphenol, 4,4'-(3,3-dimethylcyclohexan-1,1-diyl)diphenol, oder 4,4'-(2,4,4-trimethylcyclopentan-1,1-diyl)diphenol gebildet sein.

Ein erfindungsgemäßes Polycarbonatderivat kann beispielsweise gemäss der Literaturstelle DE 38 32 396.6 aus Diphenolen der Formel (Ia) hergestellt werden, deren Offenbarungsgehalt hiermit vollumfänglich in den Offenbarungsgehalt dieser Beschreibung aufgenommen wird.

Es können sowohl ein Diphenol der Formel (Ia) unter Bildung von Homopolycarbonaten als auch mehrere Diphenole der Formel (Ia) unter Bildung von Copolycarbonaten verwendet werden (Bedeutung von Resten, Gruppen und Parametern, wie in Formel I).

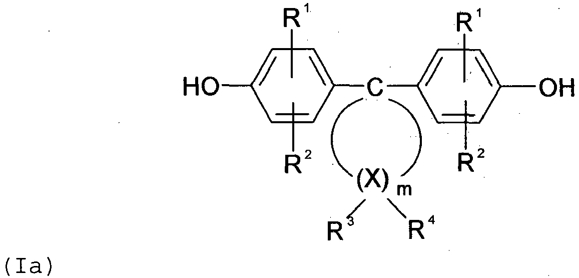

Ausserdem können die Diphenole der Formel (Ia) auch im Gemisch mit anderen Diphenolen, beispielsweise mit denen der Formel (Ib)

HO - Z - OH (Ib),

zur Herstellung von hochmolekularen, thermoplastischen, aromatischen Polycarbonatderivaten verwendet werden.

Geeignete andere Diphenole der Formel (Ib) sind solche, in denen Z ein aromatischer Rest mit 6 bis 30 C-Atomen ist, der einen oder mehrere aromatische Kerne enthalten kann, substituiert sein kann und aliphatische Reste oder andere cycloaliphatische Reste als die der Formel (Ia) oder Heteroatome als Brückenglieder enthalten kann.

Beispiele der Diphenole der Formel (Ib) sind: Hydrochinon, Resorcin, Dihydroxydiphenyle, Bi-(hydroxyphenyl)-alkane, Bis-(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, alpha , alpha '-Bis-(hydroxyphenyl)-diisopropylbenzole sowie deren kernalkylierte und kernhalogenierte Verbindungen.

Diese und weitere geeignete Diphenole sind z.B. in den Literaturstellen US-A 3 028 365, 2 999 835, 3 148 172, 3 275 601, 2 991 273, 3 271 367, 3 062 781, 2 970 131 und 2 999 846, in den Literaturstellen DE-A 1 570 703, 2 063 050, 2 063 052, 2 211 956, der Fr-A 1 561 518 und in der Monographie "H. Schnell, Chemistry and Physics of Polycarbonates, Interscience Publishers, New York 1964", beschrieben, welche hiermit vollumfänglich in den Offenbarungsgehalt der vorliegenden Anmeldung aufgenommen werden.

Bevorzugte andere Diphenole sind beispielsweise: 4,4'-Dihydroxydiphenyl, 2,2-Bis-(4-hydroxyphenyl)-propan, 2,4-Bis-(4-hydroxyphenyl)-2-methylbutan, 1,1-Bis-(4-hydroxyphenyl)-cyclohexan, alpha , alpha -Bis-(4-hydroxyphenyl)-p-diisopropylbenzol, 2,2-Bis-(3-methyl-4-hydroxyphenyl)-propan, 2,2-Bis-(3-chlor-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan, 1,1-Bis-(3,5-dimethyl-4-hydroxyphenyl)-cyclohexan, alpha , alpha -Bis-(3,5-dimethyl-4-hydroxyphenyl)-p-diisopropylbenzol, 2,2-Bis-(3,5-dichlor-4-hydroxyphenyl)-propan und 2,2-Bis-(3,5-dibrom-4-hydroxyphenyl)-propan.

Besonders bevorzugte Diphenole der Formel (Ib) sind beispielsweise: 2,2-Bis-(4-hydroxyphenyl)-propan, 2,2-Bis-(3,5-dimethyl-4-hydroxyphenyl)-propan, 2,2-Bis-(3,5-dichlor-4-hydroxyphenyl)-propan, 2,2-Bis-(3,5-dibrom-4-hydroxyphenyl)-propan und 1,1-Bis-(4-hydroxyphenyl)-cyclohexan. Insbesondere ist 2,2-Bis-(4-hydroxyphenyl)-propan bevorzugt. Die anderen Diphenole können sowohl einzeln als auch im Gemisch eingesetzt werden.

Das molare Verhältnis von Diphenolen der Formel (Ia) zu den gegebenenfalls mitzuverwendenden anderen Diphenolen der Formel (Ib), soll zwischen 100 Mol-% (Ia) zu 0 Mol-% (Ib) und 2 Mol-% (Ia) zu 98 Mol-% (Ib), vorzugsweise zwischen 100 Mol-% (Ia) zu 0 Mol-% (Ib) und 10 Mol-% (Ia) zu 90 Mol-% (Ib) und insbesondere zwischen 100 Mol-% (Ia) zu 0 Mol-% (Ib) und 30 Mol-% (Ia) zu 70 Mol-% (Ib) und ganz besonders zwischen 100 Mol-% (Ia) zu 0 Mol-% (Ib) und 50 Mol-% (Ia) zu 50 Mol-% (Ib) liegen.

Die hochmolekularen Polycarbonate aus den Diphenolen der Formel (Ia), gegebenenfalls in Kombination mit anderen Diphenolen, können nach den bekannten Polycarbonat-Herstellungsverfahren hergestellt werden. Dabei können die verschiedenen Diphenole sowohl statistisch als auch blockweise miteinander verknüpft sein.

Die erfindungsgemäss eingesetzten Polycarbonatderivate können in an sich bekannter Weise verzweigt sein. Wenn die Verzweigung gewünscht wird, kann sich in bekannter Weise durch Einkondensieren geringer Mengen, vorzugsweise Mengen zwischen 0,05 und 2,0 Mol-% (bezogen auf eingesetzte Diphenole), an drei- oder mehr als dreifunktionellen Verbindungen, insbesondere solchen mit drei oder mehr als drei phenolischen Hydroxylgruppen, erreicht werden.Einige Verzweiger mit drei oder mehr als drei phenolischen Hydroxylgruppen sind: Phloroglucin, 4,6-Dimethyl-2,4,6-tri-(4-hydroxyphenyl)-hepten-2, 4,6-Dimethyl-2,4,6-tri-(4-hydroxyphenyl)-heptan, 1,3,5-Tri-(4-hydroxyphenyl)-benzol, 1,1,1-Tri-(4-hydroxyphenyl)-ethan, Tri-(4-hydroxyphenyl)-phenylmethan, 2,2-Bis-[4,4-bis-(4-hydroxyphenyl)-cyclohexyl]-propan, 2,4-Bis-(4-hydroxyphenyl-isopropyl)-phenol, 2,6-is-(2-hydroxy-5-methyl-benzyl)-4-methylphenol, 2-(4-hydroxyphenyl)-2-(2,4-dihydroxyphenyl)-propan, Hexa-[4-(4-hydroxyphenyl-isopropyl)-phenyl]-orthoterephthalsäureester, Tetra-(4-hydroxyphenyl)-methan, Tetra-[4-(4-hydroxyphenyl-isopropyl)phenoxy]-methan und 1,4-Bis-[4',4''-dihydroxytriphenyl)-methyl]-benzol. Einige der sonstigen dreifunktionellen Verbindungen sind 2,4-Dihydroxybenzoesäure, Trimesinsäure, Cyanurchlorid und 3,3-Bis-(3-methyl-4-hydroxyphenyl)-2-oxo-2,3-dihydroindol.

Als Kettenabbrecher zur an sich bekannten Regelung des Molekulargewichts der Polycarbonatderivate dienen monofunktionelle Verbindungen in üblichen Konzentraten. Geeignete Verbindungen sind z.B. Phenol, tert.-Butylphenole oder andere Alkyl-substituierte Phenole. Zur Regelung des Molekulargewichts sind insbesondere kleine Mengen Phenole der Formel (Ic) geeignet 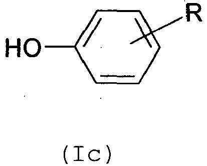 worin
R einen verzweigten C₈- und/oder C₉-Alkylrest darstellt.

Bevorzugt ist im Alkylrest R der Anteil an CH₃-Protonen zwischen 47 und 89 % und der Anteil der CH- und CH₂-Protonen zwischen 53 und 11 %; ebenfalls bevorzugt ist R in o- und/oder p-Stellung zur OH-Gruppe, und besonders bevorzugt die obere Grenze des ortho-Anteils 20 %. Die Kettenabbrecher werden im allgemeinen in Mengen von 0,5 bis 10, bevorzugt 1,5 bis 8 Mol-%, bezogen auf eingesetzte Diphenole, eingesetzt.

Die Polycarbonatderivate können vorzugsweise nach dem Phasengrenzflächenverhalten (vgl. H. Schnell "Chemistry and Physics of Polycarbonates", Polymer Reviews, Vol. IX, Seite 33ff., Interscience Publ. 1964) in an sich bekannter Weise hergestellt werden.

Hierbei werden die Diphenole der Formel (Ia) in wässrig alkalischer Phase gelöst. Zur Herstellung von Copolycarbonaten mit anderen Diphenolen werden Gemische von Diphenolen der Formel (Ia) und den anderen Diphenolen, beispielsweise denen der Formel (Ib), eingesetzt. Zur Regulierung des Molekulargewichts können Kettenabbrecher z.B. der Formel (Ic) zugegeben werden. Dann wird in Gegenwart einer inerten, vorzugsweise Polycarbonat lösenden, organischen Phase mit Phosgen nach der Methode der Phasengrenzflächenkondensation umgesetzt. Die Reaktionstemperatur liegt zwischen 0°C und 40°C.

Die gegebenenfalls mitverwendeten Verzweiger (bevorzugt 0,05 bis 2,0 Mol-%) können entweder mit den Diphenolen in der wässrig alkalischen Phase vorgelegt werden oder in dem organischen Lösungsmittel gelöst vor Phosgenierung zugegeben werden. Neben den Diphenolen der Formel (Ia) und gegebenenfalls andern Diphenolen (Ib) können auch deren Mono- und/oder Bis-chlorkohlensäureester mitverwendet werden, wobei diese in organischen Lösungsmitteln gelöst zugegeben werden. Die Menge an Kettenabbrechern sowie an Verzweigern richtet sich dann nach der molaren Menge von Diphenölat-Resten entsprechend Formel (Ia) und gegebenenfalls Formel (Ib); bei Mitverwendung von Chlorkohlensäureestern kann die Phosgenmenge in bekannter Weise entsprechend reduziert werden.

Geeignete organische Lösungsmittel für die Kettenabbrecher sowie gegebenenfalls für die Verzweiger und die Chlorkohlensäureester sind beispielsweise Methylenchlorid, Chlorbenzol, insbesondere Mischungen aus Methylenchlorid und Chlorbenzol. Gegebenenfalls können die verwendeten Kettenabbrecher und Verzweiger im gleichen Solvens gelöst werden.

Als organische Phase für die Phasengrenzflächenpolykondensation dienen beispielsweise Methylenchlorid, Chlorbenzol sowie Mischungen aus Methylenchlorid und Chlorbenzol.

Als wässrige alkalische Phase dient beispielsweise NaOH-Lösung. Die Herstellung der Polycarbonatderivate nach dem Phasengrenzflächenverfahren kann in üblicher Weise durch Katalysatoren wie tertiäre Amine, insbesondere tertiäre aliphatische Amine wie Tributylamin oder Triethylamin katalysiert werden; die Katalysatoren können in Mengen von 0,05 bis 10 Mol-%, bezogen auf Mole an eingesetzten Diphenolen, eingesetzt werden. Die Katalysatoren können vor Beginn der Phosgenierung oder während oder auch nach der Phosgenierung zugesetzt werden.

Die Polycarbonatderivate können nach dem bekannten Verfahren in homogener Phase, dem sogenannten "Pyridinverfahren" sowie nach dem bekannten Schmelzeumesterungsverfahren unter Verwendung von beispielsweise Diphenylcarbonat anstelle von Phosgen hergestellt werden.

Die Polycarbonatderivate können linear oder verzweigt sein, sie sind Homopolycarbonate oder Copolycarbonate auf Basis der Diphenole der Formel (Ia).

Durch die beliebige Komposition mit anderen Diphenolen, insbesondere mit denen der Formel (Ib) lassen sich die Polycarbonateigenschaften in günstiger Weise variieren. In solchen Copolycarbonaten sind die Diphenole der Formel (Ia) in Mengen von 100 Mol-% bis 2 Mol-%, vorzugsweise in Mengen von 100 Mol-% bis 10 Mol-% und insbesondere in Mengen von 100 Mol-% bis 30 Mol-% und ganz besonders von 100 Mol-% bis 50 Mol-%, bezogen auf die Gesamtmenge von 100 Mol-% an Diphenoleinheiten, in Polycarbonatderivaten enthalten.

Eine besonders vorteilhafte Ausführungsform der Erfindung ist dadurch gekennzeichnet, dass das Polycarbonatderivat ein Copolymer enthaltend, insbesondere bestehend aus, Monomereinheiten M1 auf Basis Bisphenol A sowie Monomereinheiten M2 auf Basis des geminal disubstituierten Dihydroxydiphenylcycloalkans, vorzugsweise des 4,4'-(3,3,5-trimethylcyclohexan-1,1-diyl)diphenols, ist, wobei das Molverhältnis M2/M1 vorzugsweise größer als 0,5, insbesondere größer als 0,8, beispielsweise größer als 1,0 ist. Denn bei solchen Copolymeren wurde überraschenderweise festgestellt, dass die Glastemperatur nach einem ersten Aufheizzyklus von Tg unter 150 °C bei einem zweiten Aufheizzyklus erhöht sein kann, was die Stabilität des erhaltenen Verbundes deutlich erhöht.

Ganz besonders bevorzugt ist eine flüssige Zubereitung enthaltend: A) 1 bis 30 Gew.-% eines erfindungsgemäß eingesetzten Polycarbonatderivates, und B) 70 bis 99 Gew.-% eines organischen Lösungsmittels oder Lösungsmittelgemisches.

Die eingesetzten organischen Lösungsmittel sind vorzugsweise halogenfreie Lösungsmittel. In Frage kommen insbesondere aliphatische, cycloaliphatische, aromatische Kohlenwasserstoffe, wie Mesitylen, 1,2,4-Trimethylbenzol, Cumol und Solvent Naptha, Toluol, Xylol; Ester, wie Methylacetat, Ethylacetat, Butylacetat, Methoxypropylacetat, Ethyl-3-ethoxypropionat. Bevorzugt sind Mesitylen, 1,2,4-Trimethylbenzol, Cumol und Solvent Naptha, Toluol, Xylol, Essigsäuremethylester, Essigsäureethylester, Methoxypropylacetat. Ethyl-3-ethoxypropionat. Ganz besonders bevorzugt sind: Mesitylen (1,3,5-Trimethylbenzol), 1,2,4-Trimethylbenzol, Cumol (2-Phenylpropan), Solvent Naptha und Ethyl-3-ethoxypropionat.

Ein geeignetes Lösungsmittelgemisch umfasst beispielsweise L1) 0 bis 10 Gew.-%, vorzugsweise 1 bis 5 Gew.-%, insbesondere 2 bis 3 Gew.-%, Mesitylen, L2) 10 bis 50 Gew.-%, vorzugsweise 25 bis 50 Gew.-%, insbesondere 30 bis 40 Gew.-%, 1-Methoxy-2-propanolacetat, L3) 0 bis 20 Gew.-%, vorzugsweise 1 bis 20 Gew.-%, insbesondere 7 bis 15 Gew.-%, 1,2,4-Trimethylbenzol, L4) 10 bis 50 Gew.-%, vorzugsweise 25 bis 50 Gew.-%, insbesondere 30 bis 40 Gew.-%, Ethyl-3-ethoxypropionat, L5) 0 bis 10 Gew.-%, vorzugsweise 0,01 bis 2 Gew.-%, insbesondere 0,05 bis 0,5 Gew.-%, Cumol, und L6) 0 bis 80 Gew.-%, vorzugsweise 1 bis 40 Gew.-%, insbesondere 15 bis 25 Gew.-%, Solvent Naphtha, wobei die Summe der Komponenten L1 bis L6 stets 100 Gew.-% ergibt. Anstelle von L2 und/oder L4 oder zusätzlich kann das Lösungsmittelgemisch auch L7) mit 10 bis 50 Gew.-%, vorzugsweise 25 bis 50 Gew.-%, insbesondere 30 bis 60 Gew.-%, Butylglykol-Acetat enthalten, wobei die Summe der verwendeten Komponenten L1 bis L7 stets 100 Gew.-% ergibt.

Der Begriff der Matrix bedeutet im Rahmen der Erfindung, dass der die Matrix bildende Polymerwerkstoff die wesentliche strukturelle Komponente bildet, in welcher die weiteren Komponenten eingebettet und verteilt, vorzugsweise homogen verteilt, sind. Als homogene Verteilung wird bezeichnet, dass die Mengen der weiteren Komponenten, sei es auf molekularer Basis, sei es als Partikel, in jedem Volumenelement gleich sind, zumindest, bezogen auf Volumenelemente der Matrix von 1000 µm³, maximal um weniger als 10% voneinander abweichen.

Die Leuchtsubstanz ist eine organische Substanz, insbesondere ein organischer lichtemittierender Halbleiter, beispielsweise ein OLED Material. Diese organische Substanz ist nicht-partikulär und vorzugsweise homogen in der Matrix verteilt, insbesondere gelöst. Hierzu gehören sogenannte small molecules (typischerweise < 3000 da), einschließlich Triplet-Emitter, sowie lumineszenzfähige Polymere, beispielsweise mit einem HOMO-LUMO Abstand im Bereich von 1,5 bis 3,5 eV.

Beispiele von small molecules umfassen N,N-diphenylaniline und Derivate hiervon, 9-H-Flourene und Derivate hiervon, Anthracene und Derivate hiervon, 4,4'-Bis[(9-ethyl-3-carbazoyl)-vinylenyl)]-anthracene, 9,10-Bis(9-ethyl-3-carbazovinylene)-1,1'-biphenyl, 4,4'-Bis(diphenylvinylenyl)-biphenyl, 1,4-Bis(9-ethyl-3-carbazovinylene)-2-methoxy-5-(2-thylhexyloxy)-benzene, 4,4'-Bis(diphenylvinylenyl)-anthracene, 1,4-Bis(9-ethyl-3-carbazovinylene)-9,9-dihexyl-fluorene, 9,9,9',9',9",9"- hexakis(hexyl)-2,7',2',7"-trifluorene, analoge Penta- und Heptaflourene, 9,9,9',9',9",9"-hexakis(octyl)-2,7',2',7''-trifluorene, analoge Penta- und Heptaflourene, 3,7-Bis-(9,9-di-n-hexylflouren-2-yl)-dibenzothiophene-S-S-dioxide, 2,7-Bis-[7-(9,9-di-n-hexylflouren-2-yl)-dibenzothiophene-S-S-dioxide-3-yl]-9,9-di-n-hexylfluorene, tetra(2-methyl-8-hydroxyquinolinato)boron, tetra(8-hydroxyquiholinato)boron, Bis(8-hydroxyquinolinato)zinc, Bis(2-methyl-8-hydroxyquinolinato)zinc, Tris(benzoylacetonato)mono(phenanathroline)europium(III), Tris(benzoylmethane)mono(phenanathroline)europium(III), Tris(benzoylmethane)mono(5-aminophenanathroline)europium(III), Tris(dinaphtoylmethane)mono(phenanathroline)europium(III), Tris(dibiphenoylmethane)mono(phenanathroline)europium(III) , Tris[di(4-(2-(2-ethoxyethoxy)ethoxy)benzoylmethane)]mono(phenanathroline)e uropium(III), Tris(dibenzoylmethane)mono(4,7-diphenylphenanathroline)europium(III), Bis(2-methyl-quinolinolato)(phenolato)aluminium(III) (Y. QIU et al., Jpn. J. Appl. Phys. 39:1151-1153 (2000)), Tris(8-hydroxyquinolinato)aluminium(III) (J. Kalinowski et al., Chemical Physics Letters 380(5-6):710-715 (2003)), Tris(8-hydroxyquinolinato)gallium(III), Platinum(III)[2-(4,6-difluorophenyl)pyridinato-N,C2)(acetyl-acetonate), Iridium(III)bis(2-(4,6-difluorophenyl)pyridinato-N,C2), Iridium(III)bis(2-(2-'-benzothienyl)pyridinato-NC3')(acetyl-acetonate), Tris(1-phenylisoquinoline)iridium(iii), Bis(1-phenylisoquinoline)(acteylacetonate(iridium(III), Iridium(III)bis(dibenzo[f,h]-quinoxaline)(acetylacentone), Iridium(III)bis(2-methyldibenzo[f,h]-quinoxaline)(acetylacetonate), Bis(2-(9,9-dibutylfluorenyl)-1-isoquinoline(acetylacetonate)iridium(III), Bis(2-(9,9-dihexylfluorenyl)-1-pyridine(acetylacetonate)iridium(III), Tris(3-methyl-1-phenyl-4-trimethyl-acetyl-5-pyrazoline)terbium(III), Tetraphenylporphyrin, Tetraphenylbutadien, Tris(2-phenylpyridine)Iridium(III), Derivate von Tris(2-phenylpyridin)Iridium(III), welche einfach oder zweifach am Phenylring an beliebiger Position methyliert oder halogeniert, insbesondere flouriert, sind, Bis(2-phenylpyridine)(Iridium Platin-Octaethylporphine, Europium-(dibenzoylmethanido)₃-basierte Moleküle (Eu(DBM)₃)X), wie Eu(DBM)₃-(dipyrido(3,2a-2',3'-c)phenazine), Eu(DBM)₃-(1,10-phenanthroline), Eu(DBM)₃-(2-(2-pyridyl)benzoxazole), Eu(DBM)₃-(2-(2-pyridyl)benzothiazole), Terbium-(Acetylaceton)₃-(1,10-phenanthroline), Substanzen gemäß der Literaturstelle S. Schrade, Proc. SPIE, Photonic Mater. And Devices, V 2003, 4991, 45 (deren Offenbarungsgehalt hiermit vollumfänglich eingeschlossen wird). Small molecules können auch derivatisiert werden mit funktionellen Gruppen, welche die Löslichkeit in organischen Lösungsmitteln, wie beispielsweise Toluol oder die im Zusammenhang mit der matrix genannten Lösungsmitteln verbessern.

Beispiele von zur Lumineszenz befähigter Polymere umfassen Poly(p-phenylen-vinylen), alkylsubstituierte, insbesondere Dialky-, beispielsweise Dimethyl-, Diethyl- oder Dibutyl-substituierte Poly(p-phenylen-vinylen) Derivate (Substituenten in para zueinander), Poly[2-methoxy-5-(3,7-dimethyloctyloxy)-p-phenylene-vinylene), Poly[2-methoxy-5-(3,7-dimethyloctyloxy)-p-phenylene-vinylene) mit POSS (Polyoctahedral Oligomeric Silesquioxan),DMP (Dimethylphenyl), N,N-Bis(4-methyl-Phenyl)-4-aniline, oder 2,5-diphenyl-1,2,4-oxadiazole Endkappen, Poly[2-methoxy-5-(2'-ethylhexyloxy)-p-phenylene-vinylene), Poly[2-methoxy-5-(2'-ethylhexyloxy)-p-phenylene-vinylene) mit POSS oder DMP Endkappen, Poly[2,5-bis(3,7-dimethyloctyloxy)-1,4-phenylene-vinylene], Poly[2,5-bis(3,7-dimethyloctyloxy)-1,4-phenylene-vinylene], alle optional mit POSS, DMP, N,N-Bis(4-methyl-Phenyl)-4-aniline, oder 2,5-diphenyl-1,2,4-oxadiazole Endkappen, Polyfluoren, Poly(9,9-dialkylflourenyl-2,7-diyl), insbesondere Poly(9,9-dioctylflourenyl-2,7-diyl) oder Poly[9,9-di(2-ethylhexyl)-flourene,2,7-diyl] oder Poly(9,9-di{2-[2-(2-methoxy-ethoxy)ethoxy]ethyl}flourenyl-2,7-diyl), alle optional mit POSS, DMP, N,N-Bis(4-methyl-Phenyl)-4-aniline, oder 2,5-diphenyl-1,2,4-oxadiazole Endkappen, Poly-N-vinylcarbazole, Poly(p-phenylene), Alkylsubstituierte, insbesondere 2,5-Dialky-, beispielsweise Dimethyl-, Diethyl- oder Dibutyl-substituierte Poly(p-phenylen) Derivate, Poly[2-(6-cyano-6-methyl-heptyloxy)-1,4-phenylene], Poly(2,5-dioctyl-1,4-phenylene), alle optional mit POSS, DMP, N,N-Bis(4-methyl-Phenyl)-4-aniline, oder 2,5-diphenyl-1,2,4-oxadiazole Endkappen, Pöly(spiroflourene), Spiro(flourene-benzoflourene), Spiroflourene-basierte Polymere gemäß US 7,524,567 B2 oder H. Becker et al., Proc. SPIE 4464:49-58 (2002) (deren Offenbarungsgehalt hiermit vollumfänglich eingeschlossen wird), ladder-poly(p-phenylene) bzw. ladder-poly(flourene) gemäß R. Fiesel et al., Angew. Chem. 108:2233 (1996) (deren Offenbarungsgehalt hiermit vollumfänglich eingeschlossen wird), Polythiophene, Polythiophenderivate, einfach oder zweifach substituiert, PFO-OPV Copolymere gemäß A Holmes et al., Proc. SPIE 4464:42-48 (2002).

Als Copolymere kommen beispielsweise in Frage Poly[9,9-dioctyl-2,7-divinylene-flourenylene)-alt-co(9,10-anthracene)], Poly[9,9-dioctyl-2,7-divinylene-flourenylene)-alt-co{2-methoxy-5-(2-ethylhexyloxy)-1,4-phenylene}], Poly[(9,9-dioctylflourenyl-2,7-diyl)-co-(1,4-vinylenephenylene)], Poly[(9,9-dioctylflourenyl-2,7-diyl)-co-1,4-benzo-{2,1'-3}-thiadiazole)], Poly[(9,9-dihexylflourenyl-2,7-diyl)-co-(2-methoxy-5-{2-ethylhexyloxy}-1,4-phenylene)], Poly[(9,9-dihexylflourenyl-2,7-diyl)-co-(2,5-9-xylene)], Poly[(9,9-di(3,3'-N,N'-trimethylammonium)propylfluorenyl-2,7-diyl)-alt-(9,9-dioctylflourenyl-2,7-diyl)], Poly[(9,9-dioctylflourenyl-2,7-diyl)-co-(N,N'-diphenyl)-N,N'-di(p-butyl-oxyphenyl)-1,4-diaminobenzene)], Poly[(9,9-dioctylflourenyl-2,7-diyl)-co-(1,4-benzo-{2,1',3}-thiadiazole)] (9:1), alle optional mit POSS, DMP, N,N-Bis(4-methyl-Phenyl)-4-aniline, oder 2,5-diphenyl-1,2,4-oxadiazole Endkappen.

Im Rahmen der Erfindung können auch Mischungen von zumindest 2, aber auch 3, 4 oder mehr, verschiedenen zu Lichtemission befähigten Substanzen eingesetzt werden, insbesondere auch bei verschiedenen Farben emittierende Substanzen, wodurch dann Mischfarben sich einstellen, was die Analyse und folglich Fälschung zusätzlich erschwert. Werden beispielsweise blau, grün und rot emittierende Materialien eingesetzt, läßt sich durch Variation der Mengenverhältnisse der verschiedenen Substanzen zueinander praktisch jede Farbe des Spektrums realisieren.

Im Rahmen der Erfindung ist ein elektrisch leitfähiges Material enthaltendes Pigment oder eine Mischung verschiedener solcher Pigmente in der Matrix vorgesehen. Elektrisch leitfähige Pigmente enthalten zumindest eine elektrisch leitfähige Schicht oder elektrisch leitfähige Partikel oder bestehen hieraus. Dabei ist es nicht erforderlich, wenn auch bevorzugt, dass das Pigment in der Matrix homogen verteilt ist. Insofern kommen sowohl sogenannte Leafing-Pigmente (welche sich beim aushärten der Matrix an die Oberfläche orientieren) als auch Non-leafing-Pigmente in Frage. Das Pigment kann grundsätzlich transparent oder nicht-transparent sein.

Der Zusatz elektrisch leitfähiger Pigmente ist insbesondere beim Einsatz von Elektroluminophoren als Lumineszenzsubstanz vorteilhaft, da damit eine zuverlässige und berührungslose Anregung der Lumineszenz mit elektrischen Wechselfeldern sichergestellt werden kann. Bei plättchenförmigen leitfähigen Pigmenten wirken diese zudem als Feldverstärker aufgrund der bei dieser Pigmentform vorliegenden scharfen Kanten oder Spitzen.

Die elektrisch leitfähige Schicht bzw. ein elektrisch leitfähiges Partikel kann beispielsweise ein oder mehrere mittels Dotierung leitfähig gemachte Metalloxide, z.B. Zinnoxid, Zinkoxid, Indiumoxid, und/oder Titanoxid aufweisen bzw. hieraus bestehen. Zur Dotierung kommen Ga, Al, In, Th, Ge, Sn, P, Ar, Sb, Se, Te, W und/oder F in Frage. Es sind auch Materialien einsetzbar, welche auf einer Trägerschicht, beispielsweise auf Basis Titandioxid, synthetischem oder natürlichen Glimmer, anderen Schichtsilikaten, Glas, Siliziumdioxid, und/oder Al₂O₃ basieren und hierauf die elektrisch leitfähige Schicht tragen, vorzugsweise von dieser Schicht umhüllt sind. Neben der Trägerschicht und der elektrisch leitfähigen Schicht können auch sonstige Schichten vorhanden sein, beispielsweise enthaltend Metalloxide, Metaloxidhydrate, Metallsuboxide, Metallfluoride, Metallnitride, Metalloxynitride oder Mischungen solcher Substanzen. Vorzugsweise sind die Trägerschicht und/oder sonstige Schichten, sofern vorgesehen, und/oder die elektrisch leitfähige Schicht optisch transparent bzw. im Wesentlichen transparent, d.h. sie transmittieren mindestens 10 %, vorzugsweise mindestens 70 % des auftreffenden Lichtes. Dabei können die transparenten oder semitransparaten Schichten farblos oder farbig sein. Die Farbeigenschaften der elektrisch leitfähigen Pigmente lassen sich auch durch die zusätzlichen Schichten modifizieren, insbesondere, wenn sie sich unterhalb der leitfähigen Schicht bzw. zwischen Trägerschichtschicht und leitfähiger Schicht befinden. Die Aufbringung von sonstigen Schichten auf der elektrisch leitfähigen Schicht kann die Leitfähigkeit der elektrisch leitfähigen Schicht nach Maßgabe von Vorgaben anpassen.

Das elektrisch leitfähige Pigment ist vorzugsweise ein mit mindestens einer elektrisch leitfähigen Metalloxidschicht, insbesondere aus mit Antimon dotiertem Zinnoxid, beschichteter Glimmer. Zusätzlich können auf oder unter der elektrisch leitfähigen Schicht eine oder mehrere Metalloxidschichten, beispielsweise eine Titanoxidschicht, vorgesehen sein.

Der Durchmesser eines elektrisch leitfähigen Pigments liegt vorzugsweise im Bereich von 0,1 µm bis 500 µm, vorzugsweise 2 µm bis 100 µm, besonders bevorzugt 5 µm bis 70 µm. Eine enge Teilchengrößenverteilung ist dabei bevorzugt. Vorzugsweise werden plättchenförmige elektrisch leitfähige Pigmente eingesetzt. Das Aspektverhältnis (Durchmesser / Dicke) bei plättchenförmigen leitfähigen Pigmenten beträgt typischerweise zumindest 2:1, insbesondere zumindest 10:1, besser zumindest 100:1.

Als besonders transparent bei hoher Leitfähigkeit zeigen sich elektrisch leitfähige plättchenförmige Pigmente, deren Anzahl-gewichtete mittlere Kornfläche F50 (Kornfläche: Größe einer Hauptfläche) zumindest 150 µm², insbesondere zumindest 200 µm² ist. Dabei ist es vorteilhaft, wenn der Anzahl-gewichtete Anteil an Pigmenten mit einer Kornfläche vorzugsweise von weniger als 80 µm² nicht mehr als 33%, insbesondere weniger als 25%, bezogen auf die Gesamtmenge an elektrisch ieitfähigem Pigment, ist. Noch besser ist ein Anteil mit einer Kornfläche kleiner 40 µm² von nicht mehr als 15%, insbesondere nicht mehr als 10%. Diese Verringerung von Feinanteilen verringert die Lichtstreuung und damit eine Trübung der Markierungsschicht. Die mittlere Kornfläche liegt idealerweise, bezogen auf die Transparenz, bei 1000 µm² und kann bis zu 4000 µm² und mehr betragen.

Geeignete elektrisch leitfähige Pigmente sind beispielsweise von führenden deutschen Anbietern von Spezialpigmenten kommerziell erhältlich.

Ebenso geeignet sind in der Beschichtungsmitteltechnologie gängige Metalleffektpigmente, beispielsweise auf Al-Basis, wie Al-MgF. Andere Basismetalle umfassen Kupfer, Bronze, Gold, Silber, Blei, Zink und Zinn. Auch in Frage kommen Plätchen aus Kohlenstoff, wie sie beispielsweise aus Kohlenstoff-Pseudoeinkristallen erhältlich sind. Bei den Partikeldimensionen gelten die vorstehend gemachten Angaben analog.

Anstelle von plättchenförmigen leitfähigen Pigmenten sind auch sogenannte Nanorods einsetzbar. Als Materialien kommen insbesondere die vorstehend bereits diskutierten Metalle (insbesondere silberfarbene), Legierungen und Halbleiter in Frage, aber auch aus Kohlenstoff. Längen liegen typischweise im Bereich von 1-200 nm, das Aspektverhältnis (Länge: Durchmesser) im Bereich 3-100, meist 3-20. Ebenso können Nanotubes eingesetzt werden, deren Durchmesser typischerweise kleiner als 100 nm, meist kleiner als 10 nm, ist. Insbesondere Nanotubes mit Kohlenstoffgerüst kommen in Frage. Aber auch Bornitrid, Molybdän-, Wolfram-, oder Kupfersulfid, Nickel- oder Cadmiumchlorid, Cadmiumiodid, oder andere Sulfide oder Halogenide kommen in Frage. Nanotubes können ein- oder mehrwandig sein. Die Enden können offen oder geschlossen sein. Das Innere kann leer sein, aber auch gefüllt. Letzteres wird sich empfehlen bei Röhrenstrukturen, welche selbst nicht leitend bzw. halbleitend sind. Eine Füllung wird dann eine leitfähige Species, insbesondere Metall, wie beispielsweise Blei, umfassen.

Es ist auch möglich, Mischungen der vorstehend genannten Pigmente einzusetzen, wodurch durch unterschiedliche Austrittsarbeiten der verschiedenen Pigmentsorten lokale Diodenstrukturen entstehen können bei Erreichung der geeigneten HOMO-/LUMO Niveaus der zur Lichtemission befähigten Substanz bzw. Partikel.

Die elektrisch leitfähigen Pigmente sind in der Matrix vorzugsweise im Wesentlichen parallel zu einer Hauptfläche bzw. einer Oberfläche der (ausgehärteten) Matrix angeordnet. Die Matrix selbst ist im Rahmen des Sicherheitselementes typischerweise als Film, Beschichtungsmittelschicht, Druckschicht oder Folie ausgebildet. Die Schichtdicke liegt in der Regel im Bereich von 5 µm bis 500 µm, insbesondere 20 µm bis 500 µm.

Zur Verbesserung der Elektroluminszenz kann in der Matrix auch ein Ladungsträgertransportmaterial vorgesehen sein. Dies empfiehlt sich insbesondere beispielsweise bei Triplettemittern, was dann die benötigte Menge an Triplettemittersubstanz für eine vorgegebene Lumineszenzintensität verringert. Dabei handelt es sich typischerweise um Lochtransportmaterialien und Elektrontransportmaterialien. Beispiele für Lochtransportmaterialien sind: Arylamine, Isoindole, N,N'-Bis(3-methylphenyl)-N,N'-bis(phenyl)benzidine, N,N'-Bis(4-methylphenyl)-N,N'-bis(phenyl)benzidine, N,N'-Bis(2-naphtalenyl)-N,N'-bis(phenyl)benzidine, 1,3,5-Tris(3-methyldiphenylamino)benzene, N,N'-Bis(1-naphtalenyl)-N,N'-bis(phenyl)behzidine, N,N'-Bis(2-naphtalenyl)-N,N'-bis(phenyl)benzidine, 4,4',4"-Tris(N,N-phenyl-3-methylphenylamino)triphenylamine, 4,4',N,N'-Diphenylcarbazole, Poly[9,9-dihexylfluorenyl-2,7-diyl)-co-(N,N'bis{p-butylphenyl}-1,4-diaminophenylene)], Poly[(9,9-dioctylfluorenyl-2,7-diyl)-co-(N,N'-bis(4-butylphenyl-1,1'-bi-phenylene-4,4-diamine)], Poly(N,N'-bis(4-butylphenyl)-N,N'-bis(phenyl)benzidine, N,N'-bis(1-naphtalenyl)-N,N'-bis(phenyl)-9,9-spirobifluorene, N,N'-bis(3-methylphenyl)-N,N'-bis(phenyl)-9,9-spirobifluorene, N,N'-bis(3-methylphenyl)-N,N'-bis(phenyl)-9,9-dimethylfluorene. Als Lochtransportmaterial, eignet sich insbesondere N,N,N',N'-Tetrakis(4-methylphenyl)benzidine. Bei der Verwendung von Triplettemittern neben Elektrolumineszenzmaterialien und Lochtransportmaterialien wird vorzugsweise auch ein zusätzliches Matrixpolymer verwendet, beispielsweise Polyvinylkarbazole (PVK) oder Polystryrol (PS).

Beispiele für Elektronentransportmaterialien sind: Oxadiazole, Imidazole, 8-Hydroxyquinolinolato-lithium, 2-(4-biphenyl)-5-(4-tert.-butylphenyl)-1,3,4-oxadiazole, 4,7-diphenyl-1,10-phenanthroline, 2,2',2''-(1,3,5-benzinetriyl)-tris(1-phenyl-1-H-benzimidazole), 2,9-dimethyl-4,7-diphenyl-a,10-phenanthroline, Bis(2-methyl-8-quinolinolate)-4-(phenylphenolato)aluminium. Eine beispielhafte Kombination ist Tris(2-(4-tolyl)pyridinato-N,C2)iridium(III) als Elektroluminszenzmaterial, N,N'-Bis(4-methylphenyl)-N,N'-bis(phenyl)benzidine als Lochtransportmaterial und 2,2',2"-(1,3,5-benzinetriyl)-tris(1-phenyl-1-H-benzimidazole) als Elektrontransportmaterial.

Die Matrix kann zusätzlich auch Konversionsleuchtstoffe enthalten. Hierzu wird lediglich beispielsweise auf die Literaturstelle EP2229424 in Bezug auf geeignete Konversionsleuchtstoffe verwiesen. Konversionsleuchtstoffe konvertieren zumindest einen Teil der Primärstrahlung in eine Sekudärstrahlung anderer Wellenlänge. Dadurch wird eine Verschiebung des Emissionsspektrums erzielt. Konversionsleuchtstoffe ermöglichen also bei einer vorgegeben Emissionswellenlänge des Primärstrahlers dennoch eine Variation der Emissionswellenlänge, i.e. eine definierte vorgegebene Modifikation derselben, wodurch eine größere Variabilität in Hinblick auf die beobachtbare Farbe bzw. Emissionswellenlänge erzielt wird.

Ansonsten kann die Matrix zusätzlich eine oder mehrere Substanzen oder Materialien aus der Gruppe bestehend aus Farbpigmente, Effektpigmente, optisch variable Pigmente, UV-Blocker, Konservierungsstoffe, und Stabilisatoren enthalten. Bei den Pigmenten sind insbesondere lasersensitive Pigmente, wie beispielsweise in der Literaturstelle WO2010/006583A beschrieben, einsetzbar, was in der dort beschriebenen Weise auch eine Modulation der Lumineszenz erlaubt.

In Bezug auf zusätzliche (und von dem eingesetzten elektrisch leitfähigen Pigment verschiedene) Pigmente ist es möglich, dass die Matrix zusätzlich ein organisches oder anorganisches (Absorptions-) Farbpigment und/oder ein Effektpigment oder eine Mischung verschiedener solcher Pigmente aufweist. Dabei kann es sich beispielsweise um mindestens ein plättchenförmiges Effektpigment und/oder ein organisches oder anorganisches Farbpigment handeln.

Als plättchenförmige Effektpigmente werden plättchenförmige Perlglanzpigmente, überwiegend transparente oder semitransparente Interferenzpigmente sowie Metalleffektpigmente bezeichnet. Auch Flüssigkristallpigmente, so genannte LCPs (Liquid Crystal Pigments), oder strukturierte Polymerplättchen, so genannte holographische Pigmente, zählen hierzu. Diese plättchenförmigen Pigmente sind aus einer oder mehreren Schichten aus gegebenenfalls unterschiedlichen Materialien aufgebaut.

Perlglanzpigmente bestehen aus transparenten Plättchen mit hoher Brechzahl und zeigen bei paralleler Orientierung durch Mehrfachreflexion einen charakteristischen Perlglanz. Solche Perlglanzpigmente, die zusätzlich auch Interferenzfarben zeigen, werden als Interferenzpigmente bezeichnet.

Obwohl natürlich auch klassische Perlglanzpigmente wie TiO₂-Plättchen, basisches Bleicarbonat, BiOCl-Pigmente oder Fischsilberpigmente prinzipiell geeignet sind, werden als plättchenförmige Effektpigmente vorzugsweise Interferenzpigmente oder Metalleffektpigmente eingesetzt, welche auf einem anorganischen plättchenförmigen Träger mindestens eine Beschichtung aus einem Metall, Metalloxid, Metalloxidhydrat oder deren Gemischen, einem Metallmischoxid, Metallsuboxid, Metalloxinitrid, Metallfluorid, BiOCl oder einem Polymer aufweisen. Die Metalleffektpigmente weisen bevorzugt mindestens eine Metallschicht auf.

Der anorganische plättchenförmige Träger besteht vorzugsweise aus natürlichem oder synthetischem Glimmer, Kaolin oder anderen Schichtsilikaten, aus Glas, SiO₂, TiO₂, Al₂O₃, Fe₂O₃, Polymerplättchen, Graphitplättchen oder aus Metallplättchen, wie beispielsweise aus Aluminium, Titan, Bronze, Silber, Kupfer, Gold, Stahl oder diversen Metallegierungen. Bevorzugt sind Träger aus Glimmer, Glas, Graphit, SiO₂, TiO₂ und Al₂O₃ oder deren Gemischen.

Die Größe dieser Träger ist an sich nicht kritisch. Sie weisen in der Regel eine Dicke zwischen 0,01 und 5 µm, insbesondere zwischen 0,05 und 4,5 µm auf. Die ausdehnung in der Länge bzw. Breite beträgt üblicherweise zwischen 1 und 250 pm, vorzugsweise zwischen 2 und 200 µm und insbesondere zwischen 2 und 100 µm. Sie besitzen in der Regel ein Aspektverhältnis (Verhältnis des mittleren Durchmessers zur mittleren Teilchendicke) von 2:1 bis 25000:1, und insbesondere von 3:1 bis 2000:1.

Bevorzugt besteht eine auf dem Träger aufgebrachte Beschichtung aus Metallen, Metalloxiden, Metallmischoxiden, Metallsuboxiden oder Metallfluoriden und insbesondere aus einem farblosen oder farbigen Metalloxid, ausgewählt aus TiO₂, Titansuboxiden, Titanoxinitriden, Fe₂O₃, Fe₃O₄, SnO₂, Sb₂O₃, SiO₂, Al₂O₃, ZrO₂, B₂O₃, Cr₂O₃, ZnO, CuO, NiO oder deren Gemischen. Beschichtungen aus Metallen sind vorzugsweise aus Aluminium, Titan, Chrom, Nickel, Silber, Zink, Molybdän, Tantal, Wolfram, Palladium, Kupfer, Gold, Platin oder diese enthaltenden Legierungen. Als Metallfluorid wird bevorzugt MgF₂ eingesetzt.

Als plättchenförmige Effektpigmente werden besonders bevorzugt mehrschichtige Effektpigmente eingesetzt. Diese weisen auf einem plättchenförmigen, vorzugsweise nichtmetallischen Träger mehrere Schichten auf, welche vorzugsweise aus den vorab genannten Materialien bestehen und verschiedene Brechzahlen in der Art aufweisen, dass sich jeweils mindestens zwei Schichten unterschiedlicher Brechzahl abwechselnd auf dem Träger befinden, wobei sich die Brechzahlen in den einzelnen Schichten um wenigstens 0,1 und bevorzugt um wenigstens 0,3 unterscheiden. Dabei können die auf dem Träger befindlichen Schichten sowohl nahezu transparent und farblos als auch transparent und farbig oder semitransparent sein.

Ebenso können die sogenannten LCPs, die aus vernetzten, orientierten, cholesterischen Flüssigkristallen bestehen, oder aber auch als holographische Pigmente bezeichnete strukturierte Polymerplättchen als plättchenförmige Effektpigmente eingesetzt werden.

Die eingesetzten plättchenförmigen Effektpigmente sind (ebenso, wie die elektrisch leitfähigen Pigmente) vorzugsweise transparent oder semitransparent. Dabei transmittieren semitransparente Pigmente mindestens 10%, transparente Pigmente hingegen mindestens 70% des einfallenden sichtbaren Lichtes. Solche plättchenförmigen Effektpigmente werden bevorzugt verwendet, da ihre Transparenz in einem Sicherheits- und/oder Wertprodukt zu einer großen Vielfalt an möglichen Hinter- oder Untergrundfarben beiträgt und gleichzeitig die Intensität der durch Elektrolumineszenz erzeugten Lichtemission nicht beeinträchtigt.

Bei bestimmten Ausführungsformen der vorliegenden Erfindung ist es jedoch auch möglich, wenn ein plättchenförmiges Effektpigment eingesetzt wird, das wenigstens eine Metallschicht aufweist. Insofern können auch manche Pigmente, wie hier beschrieben, die elektrisch leitfähigen Pigmente bilden bzw. diese ergänzen.

Es kann ein plättchenförmiges Effektpigmente eingesetzt werden, welches unter verschiedenen Beleuchtungs- und/oder Betrachtungswinkeln einen unterschiedlichen visuell wahrnehmbaren Farb- und/oder Helligkeitseindruck hinterläßt. Bei unterschiedlichen Farbeindrücken wird diese Eigenschaft als Farbflop bezeichnet. Insbesondere Pigmente, die einen Farbflop aufweisen, erzeugen in den damit hergestellten Sicherheitselement bzw. Sicherheits- und/oder Wertprodukten nicht kopierbare Farb- und Glanzeindrücke, welche mit dem bloßen Auge ohne Hilfsmittel gut wahrnehmbar sind. Solche Pigmente werden auch als optisch variabel bezeichnet. Die optisch variablen plättchenförmigen Effektpigmente weisen beispielsweise unter mindestens zwei verschiedenen Beleuchtungs- oder Betrachtungswinkeln mindestens zwei und höchstens vier, vorzugsweise aber unter zwei verschiedenen Beleuchtungs- oder Betrachtungswinkeln zwei oder unter drei verschiedenen Beleuchtungs- oder Betrachtungswinkeln drei optisch klar unterscheidbare diskrete Farben auf. Vorzugsweise liegen jeweils nur die diskreten Farbtöne und keine Zwischenstufen vor, das heißt, ein klarer Wechsel von einer Farbe zu einer anderen Farbe ist beim Abkippen des Sicherheitselementes, welches die optisch variablen Pigmente enthält, erkennbar. Diese Eigenschaft erleichtert dem Betrachter einerseits das Erkennen des Sicherheitselementes als solches und erschwert gleichzeitig die Kopierbarkeit dieses Merkmales, da in den handelsüblichen Farbkopierern Farbflopeffekte nicht kopiert und reproduziert werden können.

Selbstverständlich sind jedoch auch optisch variable plättchenförmige Effektpigmente einsetzbar, die beim Abkippen über verschiedene Beleuchtungs- und/oder Betrachtungswinkel einen Farbverlauf, d.h. viele verschiedene Farbtöne, wie beispielsweise den typischen Perlglanz, aufweisen. Auch solche diffusen Farbänderungen sind vom menschlichen Auge gut erfaßbar.

Um ihre volle optische Wirkung entfalten zu können, ist es von Vorteil, wenn die erfindungsgemäß eingesetzten plättchenförmigen Effektpigmente in der Markierungsschicht bzw. dem Sicherheits- und/oder Wertprodukt in orientierter Form vorliegen, d.h. sie sind nahezu parallel zu den mit dem Sicherheitselement versehenen Oberflächen des Sicherheitserzeugnisses ausgerichtet. Eine solche Ausrichtung erfolgt in der Regel bereits im wesentlichen mittels der üblichen angewandten Verfahren zur Aufbringung des Sicherheitselementes, wie beispielsweise üblichen Druckverfahren. Ebenso ist es bevorzugt, wie bereits erwähnt, wenn die elektrisch leitfähigen Pigmente entsprechend ausgerichtet sind.

Als plättchenförmige Effektpigmente können beispielsweise die im Handel erhältlichen Interferenzpigmente, welche z.B. unter der Bezeichnung Mearlin® der Firma Mearl, Metalleffektpigmente der Firma Eckhard sowie goniochromatische (optisch variable) Effektpigmente wie beispielsweise Variochrom® der Firma BASF, Chromafflair® der Firma Flex Products Inc., Helicone® der Firma Wacker oder holographische Pigmente der Firma Spectratec sowie andere gleichartige kommerziell erhältliche Pigmente eingesetzt werden. Diese Aufzählung ist jedoch lediglich als beispielhaft und nicht als abschließend anzusehen.

Als anorganische Farbpigmente sind alle gebräuchlichen transparenten und deckenden Weiß-, Bunt- und Schwarzpigmente, wie beispielsweise Berliner Blau, Bismutvanadat, Goethit, Magnetit, Hämatit, Chromoxid, Chromhydroxid, Cobaltaluminat, Ultramarin, Chrom-Eisen-Mischoxide, Spinelle wie Thenards Blau, Cadmiumsulfide und -selenide, Chromat-Pigmente oder Ruß geeignet, während als organische Farbpigmente insbesondere Chinacridone, Benzimidazole, Kupferphthalocyanin, Azopigmente, Perinone, Anthanthrone, weitere Phthalocyanine, Anthrachinone, Indigo, Thioindigo und deren Derivate, oder Karminrot zu nennen sind. Generell können sämtliche, insbesondere im Druckbereich gebräuchlichen, organischen oder anorganischen Farbpigmente eingesetzt werden.

Zur Abschirmung gegen ultraviolette Strahlung können auch Pigmente eingesetzt werden, welche UV-Licht absorbieren. Von diesen seien Titandioxid und Zinkoxid nur beispielhaft genannt.

Grundsätzlich kann ein erfindungsgemäßes Sicherheitselement auf verschiedenste Weisen hergestellt werden. Einerseits ist es beispielsweise möglich, eine Mischung aus dem Polymerwerkstoff der Matrix und den weiteren beschriebenen Komponenten herzustellen und eine Folie zu extrudieren, wobei die Extrusion nach Maßgabe des eingesetzten Polymerwerkstoffes fachüblich erfolgt. Die so erhaltene Folie kann dann ggf. in einzelne Folienstücke zertrennt und in ein Sicherheits- und/oder Wertdokument einlaminiert oder auflaminiert bzw.- geklebt werden.

Alternativ kann erfindungsgemäße druckfähige Zubereitung, insbesondere Druckfarbe, hergestellt werden. Diese enthält dann den organischen Polymerwerkstoff der Matrix, die zumindest eine Leuchtsubstanz, welche in Gegenwart des leitfähigen Pigments zur kontaktlosen Anregung von Lichtemission befähigt ist, das zumindest eine elektrisch leitfähiges Pigment, und optional zumindest ein wäßriges und/oder organisches Lösemittel (bevorzugt sind organische Lösemittel), wobei die Leuchtsubstanzubstanz nicht verkapselt ist. Zusätzlich kann die Zubereitung zumindest ein Ladüngsträgertransportmaterial enthalten, sowie die weiteren vorstehend beschriebenen sonstigen Komponenten, wie Farbpigmente, Effektpigmente, optisch variable Pigmente, UV-Blocker, Konservierungsstoffe, Rheologie modifizierende Substanzen, und Stabilisatoren.
Als organische Lösemittel kommen neben den vorstehend im Zusammenhang mit dem Polymerwerkstoff der Matrix und dessen Herstellung beschriebenen Lösungsmittel in Frage, sowie alle im Rahmen der Drucktechnologie, insbesondere der Tintenstrahldrucktechnologie, fachüblichen Lösungsmittel und Lösungsmittelgemische in Frage. Aber auch der Einsatz von wäßrigen Dispersionen, welche weniger als 10 Gew.-% organische Lösemittel enthalten, ist möglich. Dann liegt die Matrix mit ihren weiteren erfindungsgemäßen Komponenten als dispergierte filmbildende Partikel vor. Die Zubereitung kann, je nach Einsatzgebiet, als Lösung, Dispersion, Emulsion oder Paste vorliegen.

Als Drucktechniken kommen alle im Bereich der Sicherheits- und/oder Wertdokumente üblichen Techniken, wie Siebdruck, Flexodruck, Offsetdruck, Hochdruck, Tiefdruck, Lettersetdruck, Thermosublimationsdruck, oder Tintenstrahldruck in Frage. Alternativ ist natürlich auch das Aufstreichen, -Rakeln, -Rollen, Stempeln, Gießverfahren, wie Filmgiessen, Lackierverfahren, Tauchen, Walzen- oder Rasterauftragsverfahren, Schleudern, Kalandrieren usw. möglich. Als Substrat für das Aufbringen des Sicherheitselementes kommen alle im Bereich der Sicherheits- und/oder Wertdokumente üblichen Substrate in Frage, beispielsweise Kunststofffolien auf Basis von Polymeren, wie sie vorstehend im Zusammenhang mit dem Polymerwerkstoff der Matrix bereits genannt wurden. Aber auch Substrate aus Papier, Pappe, textilen Werkstoffen usw. sind möglich. Schließlich können auch beliebige Gegenstände, beispielsweise Markenprodukte, als Substrat dienen. In letzterem Falle werden durch die Aufbringung des erfindungsgemäßen Sicherheitselements dann diese Gegenstände markiert und werden somit authentisierbar und unterscheidbar von gefälschten Produkten.

Ein erfindungsgemäßes Sicherheitselement (ggf. nach Austrocknung) enthält beispielsweise: A) 0,1 bis 5 Gew.-%, insbesondere 1 bis 5 Gew.-%, der Leuchtsubstanz, B) 60 bis 95 Gew.-%, insbesondere 85 bis 95 Gew.-%, Matrix, C) 2 bis 15 Gew.-%, insbesondere 5 bis 10 Gew.-%, elektrisch leitfähiges Pigment, D) 0 bis 37,9 Gew.-%, insbesondere 0,1 bis 9 Gew.-%, Zusatzstoffe und/oder von C) verschiedene Pigmente, wobei die Summe der Komponenten A) bis D) stets 100% ergibt.

Die Erfindung betrifft des Weiteren ein Sicherheits- und/oder Wertdokument enthaltend eine Substratschicht, optional eine oder mehrere Zusatzschichten, sowie zumindest eine erfindungsgemäße Druckschicht oder Folie, wobei die Druckschicht oder Folie ganzflächig oder teilflächig auf die Substratschicht oder eine Zusatzschicht aufgebracht ist. Die Druckschicht oder Folie kann insofern in den Schichtaufbau eines Sicherheits- und/oder Wertdokument eingebaut oder hierauf aufgestapelt werden. Ein solches Dokument ist herstellbar, indem die Substratschicht und/oder Zusatzschicht aus einem organisch polymeren Werkstoff gebildet wird (beispielsweise als Folie), wobei auf die Substratschicht oder die Zusatzschicht eine erfindungsgemäße Druckschicht oder eine Folie aufgebracht wird und wobei ggf. Substratschicht und Zusatzschicht, optional zusammen mit einer Deckschicht, vor oder nach dem Aufbringen der Druckschicht oder der Folie miteinander laminiert werden. Ein solches Sicherheits- und/oder Wertdokumentes ist verifizierbar bzw. authentisierbar, indem das Sicherheits- und/oder Wertdokument physikalischen Bedingungen ausgesetzt wird, welche die Leuchtsubstanz zur Emission von Licht anregen, wobei die Lichtemission beobachtet oder gemessen wird, und wobei das Sicherheits- und/oder Wertdokument nach Maßgabe der Beobachtung oder Messung als echt oder als Fälschung eingestuft wird. Solche Bedingungen umfassen beispielsweise, dass das Dokument in eine Spaltelektrode eingebracht wird, welche mit einem elektrischen Wechselfeld beaufschlagt ist, das zur Anregung der Lichtemission dimensioniert ist.

Alle vorstehend im Zusammenhang mit dem Sicherheitselement angebrachten Detailerläuterungen sind entsprechend auf die anderen vorstehend angesprochenen Aspekte der Erfindung anwendbar.

Mit der Erfindung wird eine Reihe von Vorteilen und Einsatzmöglichkeiten erreicht. Es wird ein maschinenlesbares Sicherheitselement mit größter Vielfalt der einsetzbaren Elektrolumineszenzen, vorzugsweise im Bereich UV, sichtbares Licht und IR geschaffen. Es können Emittermaterialien eingesetzt werden, welche unterschiedliche Emissionseigenschaften (Farben/Wellenlängen) bei unterschiedlichen Anregungen, beispielsweise im Sichtbaren, UV oder elektrischer Anregung. Durch geeignete Mischungen der Emittermaterialien können praktisch beliebige Emissionsfarben/-wellenlängen realisiert werden. Weiterhin sind zeitaufgelöste und entsprechend messtechnisch detektierbare und auswertbare Effekte schaffbar, indem unterschiedliche Lebendauern angeregter Zustände und entsprechende Auswahl der Emittermaterialien vorgesehen werden. Es lassen sich folglich verschiedene Sicherheitsstufen für ein Sicherheitselement schaffen, beginnend mit der sichtbaren Farbinformation der Emission, bis hin zu (forensischen) Infomationen, wie Form des Emissionsspektrums, Abklingverhalten und Phasenverschiebungen der Emission. Es kann durch entsprechende Auswahl der Emittermaterialien gleichsam ein Fingerabdruck der Matrix geschaffen werden, welcher durch einen charakterischen Intensitätsverlauf des Emissionspektrums gekennzeichnet ist. Aufgrund der eingesetzten (organischen) Emittermaterialien ist eine chemisch qualitative und/oder quantitative Analyse des Sicherheitselements zu Fälschungszwecken erheblich erschwert. Schließlich können "Sternenhimmel"-artige Muster, wie beispielsweise in den Literaturstellen DE 10304805 A1 und WO2010/006583 beschrieben, also Zufallsmuster, erzeugt werden. Die lokale Luminenszenz hängt dann beispielsweise auch von der zufälligen lateralen Verteilung der elektrisch leitfähigen Partikel ab, welche zwar statistisch gleichverteilt sein mögen, dennoch aber im Mikrobereich (5-100-fache der lateralen Abmessung der elektrisch leitfähigen Partikel) lateral ungleich verteilt sein können. Diese Muster können auch zur Generierung von Zufallsmustern, wie sie für die Erzeugung von kryptographischen Schlüsseln notwendig sind, verwendet werden, oder als Grundlage für materialbasierte PUFs (physical unclonable functions) dienen. Des Weiteren ermöglichen diese Zufallsmuster eine elektro-optische Personalisierung und eine maschinenauswertbare Information/Identifikation als "Seriennummer", wie bereits in der Literaturstelle WO2010/006583 beschrieben.

Im Folgenden wird die Erfindung anhand von nicht limitierenden Ausführungsbeispielen näher erläutert.

### Beispiel 1: Herstellung von einsetzbaren Polycarbonatderivaten

### Beispiel 1.1: Herstellung eines ersten Polycarbonatderivats

183,3 g (0,80 Mol) Bisphenol A (2,2-Bis-(4-hydroxyphenyl)-propan, 61,1 g (0,20 Mol) 1,1-Bis-(4-hydroxyphenyl)-3,3,5-trimethylcyclohexan, 336,6 g (6 Mol KOH und 2700 g Wasser werden in einer Inertgas-Atmosphäre unter Rühren gelöst. Dann fügt man eine Lösung von 1,88 g Phenol in 2500 ml Methylenchlorid zu. In die gut gerührte Lösung würden bei pH 13 bis 14 und 21 bis 25°C 198 g (2 Mol) Phosgen eingeleitet. Danach wird 1 ml Ethylpiperidin zugegeben und noch 45 Min. gerührt. Die bisphenolatfreie wässrige Phase wird abgetrennt, die organische Phase nach Ansäuern mit Phosphorsäure mit Wasser neutral gewaschen und vom Lösungsmittel befreit.

Das Polycarbonatderivat zeigte eine relative Lösungsviskosität von 1,255.

### Beispiel 1.2: Herstellung eines zweiten Polycarbonatderivats

Analog dem Beispiel 1.1 wurde eine Mischung aus 127,1 g (0,56 Mol) Bisphenol A und 137,7 g (0,44 Mol) 1,1-Bis-(4-hydroxyphenyl)-3,3,5-trimethylcyclohexan zum Polycarbonat umgesetzt.

Das Polycarbonatderivat zeigte eine relative Lösungsviskosität von 1,263.

### Beispiel 1.3: Herstellung eines dritten Polycarbonatderivats

Wie in Beispiel 1 wurde eine Mischung aus 149,0 g (0,65 Mol) Bisphenol A und 107,9 g (0,35 Mol) 1,1-Bis-(4-hydroxyphenyl)-3,3,5-trimethylcyclohexan zum Polycarbonat umgesetzt.

Das Polycarbonatderivat zeigte eine relative Lösungsviskosität von 1,263.

### Beispiel 2.1: Herstellung einer ersten erfindungsgemäß eingesetzten flüssigen Zubereitung

Als drucktechnisch, beispielsweise mittels Siebdruck, aufbringbare flüssige Zubereitung wird die folgende Lösung hergestellt: 17,5 Gew.-Teile des Polycarbonats aus Beispiel 1.3, 82,5 Gew.-Teile des folgenden Lösungsmittel-Gemisches, bestehend aus:

| | |
|---|---|
| Mesitylen | 2,4 |
| 1-Methoxy-2-propanolacetat | 34,95 |
| 1,2,4-Trimethylbenzol | 10,75 |
| Ethyl-3-ethoxypropionat | 33,35 |
| Cumol | 0,105 |
| Solvent Naphtha | 18,45 |

Es wurde eine farblose, hochviskose Lösung mit einer Lösungsviskosität bei 20°C von 800m Pas erhalten.

Zu 90 Gew.-% dieser Lösung werden 8 Gew.-% einer handelsüblichen Lösung eines Polyfluorenes in Toluol (1,5 Gew.-% Polyfluorene in Toluol) als zur Lichtemission befägigte Komponente zugesetzt. Schließlich werden 2 Gew.-% eines elektrisch leitfähigen Pigments, beispielsweise eines im allgemeinen Teil beschriebenen Micapigments, zugegeben. Die Mischung wird homogenisiert und ist damit verwendungsfähig.

Alternativ zu der Lösung des Matrixpolymers kann auch eine entsprechende Menge der kommerziell erhältlichen Lösung APEC PUD 6581-9 (Merck) eingesetzt werden.

### Beispiel 2.2: Herstellung einer zweiten erfindungsgemäß eingesetzten flüssigen Zubereitung

Die Herstellung erfolgt analog Beispiel 2.1, wobei jedoch an Stelle der Polyflourene Lösung die gleiche Menge der folgende folgenden Lösung eingesetzt wird.

In Toluol wird eine Lösung einer Mischung aus 5% Gew.-% Iridium(III)tris(2-(4-totyl)pyridinato-N,C2) (Elektrolumineszenzmaterial), 10 Gew.-% N,N'-bis(3-methylphenyl)-N,N'-bis(phenyl)benzidine (Lochtransportmaterial, TPD), 25 Gew.-% 2-(4-biphenyl)-5-(4-tert-buthlphenyl)-1,3,4-oxadiazole (Elektrontransportmaterial, TBPO) und 60 Gew.-% Polystyrol hergestellt. Dabei beträgt die Gesamtmenge der besagten vier Substanzen 2,5 Gew.-% der fertigen Lösung.

### Beispiel 3: Herstellung eines erfindungsgemäßen Sicherheitselementes

Eine Polycarbonatfolie Makrofol ® 6-2 (Dicke ca. 100 µm) wird beispielsweise mit der Zubereitung aus Beispiel 2.1 oder 2.2 mittels Digitaldruck, beispielsweise Tintendruck, bedruckt. Alternativ kann mittels Siebdruckgearbeitet werden.

Der aufgedruckte Film enthält nach dem Austrocknen 0,5 Ges.-% der Leuchtsubstanz, 90 Gew.-% des organischen Polymerwerkstoffes der Matrix, 8 Gew.-% der leitfähigen Pigmente.

Die so erhaltene bedruckte Polycarbonatfolie kann dann mit weiteren Polycarbonatfolien laminiert werden, und zwar direkt, i.e. ohne Verwendung von zwischengelagerten Adhäsivschichten. Dabei bilden die einzelnen Folienschichten praktisch ein durchgehendes Stück Polycarbonat, da die miteinander laminierten Stoffe, einschließlich der gedruckten Strukturen, allesamt auf Polycarbonat basieren. Die Schichten lassen sich nicht mehr voneinander lösen, wodurch eine besonders hohe Fälschungssicherheit erreicht wird, da ein Zugriff auf die gedruckten Strukturen praktisch unmöglich ist.

### Beispiel 4: Verschiedene Emissionswellenlängen eines erfindungsgemäßen Sicherheitselements

Ein erfindungsgemäß hergestelltes Sicherheits- und/oder Wertdokument kann innerhalb der Druckschicht (gleiche oder verschiedene) Leuchtsubstanzen enthalten, welche bei verschiedenen Anregungsarten bei verschiedenen Wellenlängen emittieren bzw. eine Schwerpunktwellenlänge zeigen. In jedem Fall findet eine Emission bei kontaktloser elektrischer Anregung statt.

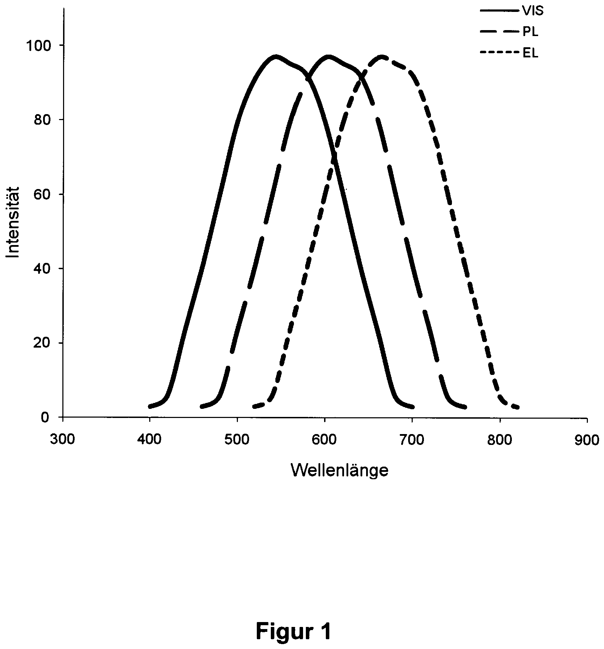

In der Figur 1 sind Spektren einer erfindungsgemäßen Ausführung dargestellt. Das mit durchgehender Linie dargestellte Spektrum ist der im Sichtbaren reflektierte (bzw. nicht absorbierte) Lichtanteil und gibt den Farbeindruck des Sicherheitselementes ohne jegliche sonstige Anregung wieder. Das kurzgestrichelte Spektrum gibt die Emission des Sicherheitselementes bei kontaktloser elektrischer Anregung wieder. Das langgestrichelte Spektrum zeigt die Emission bei Anregung mit UV. Wie man sieht, stellt sich dem Betrachter (oder einem maschinellem Prüfgerät) je nach Art der Anregung eine verschiedene Farbe dar. Je nach Art der Anregung findet eine Verschiebung oder Änderung der Form der spektral verteilten Emission statt.

## Patentansprüche

1. Sicherheitselement für ein Sicherheits- und/oder Wertdokument, enthaltend eine Matrix auf Basis eines organischen Polymerwerkstoffes, zumindest ein in der Matrix verteiltes elektrisch leitfähiges Pigment und zumindest einen in der Matrix verteilten organischen lichtemittierenden Halbleiter, welcher in Gegenwart des elektrisch leitfähigen Pigments zur kontaktlosen Anregung von Lichtemission befähigt ist und dessen Partikelgröße kleiner als 200 nm ist, wobei der organische lichtemittierende Halbleiter nicht verkapselt ist und unmittelbar von der Matrix umgeben und hierin eingebettet ist.

2. Sicherheitselement nach Anspruch 1, wobei der organische Polymerwerkstoff ausgewählt ist aus der Gruppe bestehend aus PC (Polycarbonat, insbesondere Bisphenol A Polycarbonat), PET (Polyethylenglykolterephthalat), PMMA (Polymethylmethacrylat), TPU (Thermoplastische Polyurethan Elastomere), PE (Polyethylen), PP (Polypropylen), PI (Polyimid oder Poly-trans-Isopren), PVC (Polyvinylchlorid), Polystyrol, Polyacrylate und Methacrylate, Vinylester, ABS und Copolymere solcher Polymere, vorzugsweise ein Polycarbonatderivat ist, insbesondere auf Basis Bisphenol A, vorzugsweise auf Basis eines geminal disubstituierten Dihydroxydiphenyl-cycloalkans.

3. Sicherheitselement nach einer Ansprüche 1 bis 2, wobei das elektrisch leitfähige Pigment plättchenförmig, insbesondere mit einem Aspektverhältnis von zumindest 2:1 sowie einem mittleren Teilchendurchmesser von 1-500 µm, und vorzugsweise transparent, oder ein Nanorod oder Nanotube ist.

4. Sicherheitselement nach einem der Ansprüche 1 bis 3, zusätzlich enthaltend zumindest ein Ladungsträgertransportmaterial.

5. Sicherheitselement nach einem der Ansprüche 1 bis 4, zusätzlich enthaltend eine oder mehrere Substanzen oder Materialien aus der Gruppe bestehend aus Farbpigmente, Effektpigmente, optisch variable Pigmente, UV-Blocker, Konservierungsstoffe, und Stabilisatoren.

6. Sicherheitselement nach einem der Ansprüche 1 bis 5 in der Ausführungsform als Druckschicht oder Folie, wobei das Sicherheitselement (ggf. nach Austrocknung) vorzugsweise enthält:
A) 0,1 bis 5 Gew.-% des organischen lichtemittierenden Halbleiters,
B) 60 bis 95 Gew.-% Matrix,
C) 2 bis 15 Gew.-% elektrisch leitfähiges Pigment,
D) 0 bis 37,9 Gew.-% Zusatzstoffe und/oder von C) verschiedene Pigmente,
wobei die Summe der Komponenten A) bis D) stets 100% ergibt.

7. Druckfähige Zubereitung, insbesondere Druckfarbe, zur Herstellung eines Sicherheitselements nach einem der Ansprüche 1 bis 6, enthaltend einen organischen Polymerwerkstoff, zumindest ein elektrisch leitfähiges Pigment, zumindest einen organischen lichtemittierenden Halbleiter, welcher in Gegenwart des elektrisch leitfähigen Pigments zur kontaktlosen Anregung von Lichtemission befähigt ist, und zumindest ein wäßriges und/oder organisches Lösemittel, wobei der organischen lichtemittierenden Halbleiter nicht verkapselt ist und eine Partikelgrößer kleiner 200 nm aufweist.

8. Zubereitung nach Anspruch 7, zusätzlich enthaltend zumindest ein Ladungsträgertransportmaterial.

9. Zubereitung nach einem der Ansprüche 7 oder 8, zusätzlich enthaltend eine oder mehrere Substanzen oder Materialien aus der Gruppe bestehend aus Farbpigmente, Effektpigmente, optisch variable Pigmente, UV-Blocker, Konservierungsstoffe, Rheologie modifizierende Substanzen, und Stabilisatoren.

10. Sicherheits- und/oder Wertdokument enthaltend eine Substratschicht, optional eine oder mehrere Zusatzschichten, sowie zumindest eine Druckschicht oder Folie nach Anspruch 6, wobei die Druckschicht oder Folie ganzflächig oder teilflächig auf die Substratschicht oder eine Zusatzschicht aufgebracht ist.

11. Verfahren zur Herstellung eines Sicherheits- und/oder Wertdokumentes nach Anspruch 10, wobei die Substratschicht und/oder Zusatzschicht aus einem Papierwerkstoff oder einem organisch polymeren Werkstoff gebildet ist, wobei auf die Substratschicht oder die Zusatzschicht eine Druckschicht oder eine Folie nach Anspruch 6 aufgebracht wird und wobei ggf. Substratschicht und Zusatzschicht, optional zusammen mit einer Deckschicht, vor oder nach dem Aufbringen der Druckschicht oder der Folie miteinander laminiert werden.

12. Verfahren zur Verifizierung eines Sicherheits- und/oder Wertdokumentes nach Anspruch 10, wobei das Sicherheits- und/oder Wertdokument physikalischen Bedingungen ausgesetzt wird, welche den organischen lichtemittierenden Halbleiter in Anwesenheit der elektrisch leitfähigen Partikel zur Emission von Licht anregen, wobei Lichtemission beobachtet oder gemessen wird, und wobei das Sicherheits- und/oder Wertdokument nach Maßgabe der Beobachtung oder Messung als echt oder als Fälschung eingestuft wird.

## Claims

1. A security element for a security and/or valuable document, comprising a matrix based on an organic polymeric material, at least one electrically conductive pigment distributed in the matrix and at least one organic light-emitting semiconductor distributed in the matrix, which in presence of the electrically conductive pigment is capable of contactlessly exciting light emission, and the particle size of which is smaller than 200 nm, the organic light-emitting semiconductor not being encapsulated and being immediately surrounded by the matrix and embedded therein.

2. The security element according to claim 1, wherein the organic polymeric material is selected from the group consisting of PC (polycarbonate, in particular bisphenol A polycarbonate), PET (polyethylene glycol terephthalate), PMMA (polymethyl methacrylate), TPU (thermoplastic polyurethane elastomers), PE (polyethylene), PP (polypropylene), PI (polyimide or poly-trans-isoprene), PVC (polyvinyl chloride), polystyrene, polyacrylate and methacrylate, vinyl ester, ABS and copolymers of such polymers, preferably is a polycarbonate derivative, in particular based on bisphenol A, preferably based on a geminally disubstituted dihydroxydiphenyl cycloalkane.

3. The security element according to one of claims 1 to 2, wherein the electrically conductive pigment is platelet-like, in particular with an aspect ratio of at least 2:1 and a mean particle diameter of 1 to 500 µm, and preferably is transparent, or a nanorod or nanotube.

4. The security element according to one of claims 1 to 3, further comprising at least one charge carrier transportation material.

5. The security element according to one of claims 1 to 4, further comprising one or more substances or materials from the group consisting of color pigments, effect pigments, optically variable pigments, UV blockers, preservation agents, and stabilizers.

6. The security element according to one of claims 1 to 5 in the embodiment as a printing layer or film, wherein the security element (if applicable after drying) preferably comprises:
A) 0.1 to 5 wt-% of the organic light-emitting semiconductor,
B) 60 to 95 wt-% of the matrix,
C) 2 to 15 wt-% of the electrically conductive pigment,
D) 0 to 37.9 wt-% of additives and/or pigments different from C),
wherein the sum of the components A) to D) is always 100 %.

7. A printable preparation, in particular a printing ink, for making a security element according to one of claims 1 to 6, comprising an organic polymeric material, at least one electrically conductive pigment, at least one organic light-emitting semiconductor, which in presence of the electrically conductive pigment is capable of contactlessly exciting light emission, and at least one aqueous and/or organic solvent, wherein the organic light-emitting semiconductor is not encapsulated, and includes a particle size smaller than 200 nm.

8. The preparation according to claim 7, further comprising at least one charge carrier transportation material.

9. The preparation according to one of claims 7 or 8, further comprising one or more substances or materials from the group consisting of color pigments, effect pigments, optically variable pigments, UV blockers, preservation agents, rheology-modifying substances, and stabilizers.

10. A security and/or valuable document comprising a substrate layer, optionally one or more additional layers, and at least one printing layer or film according to claim 6, wherein the printing layer or film is applied on the full area or a partial area of the substrate layer or of an additional layer.

11. A method for making a security and/or valuable document according to claim 10, wherein the substrate layer and/or the additional layer is formed of a paper material or an organic polymeric material, wherein on the substrate layer or additional layer a printing layer or a film according to claim 6 is applied, and wherein, if applicable, the substrate layer or the additional layer, optionally together with a cover layer, are laminated together before or after the application of the printing layer or the film.

12. The method for verifying a security and/or valuable document according to claim 10, wherein the security and/or valuable document is subjected to physical conditions, which excite the organic light-emitting semiconductor in presence of the electrically conductive particles to emission of light, wherein the light emission is observed or measured, and wherein the security and/or valuable document is classified as real or false in accordance with the observation or measurement.

## Revendications

1. Élément de sécurité pour un document de sécurité et/ou de valeur, comprenant une matrice sur la base d'un matériau polymère organique, au moins un pigment électroconducteur réparti dans la matrice et au moins un semi-conducteur luminescent organique réparti dans la matrice, qui en présence du pigment électroconducteur est capable d'exciter sans contact une émission lumineuse et dont la taille de particules est inférieure à 200 nm, le semi-conducteur luminescent organique n'étant pas encapsulé et étant entouré directement par la matrice et intégré là-dedans.

2. Élément de sécurité selon la revendication 1, dans lequel le matériau polymère organique est choisi à partir du groupe consistant en PC (polycarbonate, en particulier polycarbonate du bisphénol A), PET (téréphthalate de polyéthylène glycol), PMMA (méthacrylate de polyméthyl), TPU (élastomères de polyuréthane thermoplastique), PE (polyéthylène), PP (polypropylène), PI (polyimide ou poly-trans-isoprène), PVC (polyvinyl chloride), polystyrène, polyacrylate et méthacrylate, ester vinylique, ABS et copolymères de tels polymères, de préférence est un dérivé de polycarbonate, en particulier sur la base de bisphénol A, de préférence sur la base d'un cycloalkane de di-hydroxydiphényl gem-disubstitué.

3. Élément de sécurité selon une des revendications 1 à 2, dans lequel le pigment électroconducteur est en forme de plaquette, en particulier avec un rapport d'élancement d'au moins 2:1 et un diamè-tre de particules moyen de 1 à 500 µm, et de préférence est transparent, ou est un nanorod ou nanotube.

4. Élément de sécurité selon une des revendications 1 à 3, en outre comprenant au moins un matériau de transport de porteurs de charge.

5. Élément de sécurité selon une des revendications 1 à 4, en outre comprenant une ou plusieurs substances ou matériaux à partir du groupe consistant en pigments de couleur, pigments d'effet, pigments optiquement variables, agents bloqueurs d'U.V., agents conservateurs, et stabilisateurs.

6. Élément de sécurité selon une des revendications 1 à 5 dans la forme de réalisation d'une couche d'impression ou d'un film, dans lequel l'élément de sécurité (le cas échéant après séchage) de préférence comprend:
A) 0,1 à 5 % en poids du semi-conducteur luminescent organique,
B) 60 à 95 % en poids de la matrice,
C) 2 à 15 % en poids du pigment électroconducteur,
D) 0 à 37,9 % en poids d'additifs et/ou de pigments différents de C),
dans lequel la somme des composants A) à D) est toujours de 100 %.

7. Préparation imprimable, en particulier encre d'impression, pour fabriquer un élément de sécurité selon une des revendications 1 à 6, comprenant un matériau polymère organique, au moins un pigment électroconducteur, au moins un semi-conducteur luminescent organique, qui en présence du pigment électroconducteur est capable d'exciter sans contact une émission lumineuse, et au moins un solvant aqueux et/ou organique, dans lequel le semi-conducteur luminescent organique n'est pas encapsulé, et comporte une taille de particules inférieure à 200 nm.

8. Préparation selon la revendication 7, en outre comprenant au moins un matériau de transport de porteurs de charge.

9. Préparation selon une des revendications 7 ou 8, en outre comprenant une ou plusieurs substances ou matériaux à partir du groupe consistant en pigments de couleur, pigments d'effet, pigments optiquement variables, agents bloqueurs d'U.V., agents conservateurs, substances modifiant la rhéologie, et stabilisateurs.

10. Document de sécurité et/ou de valeur comprenant une couche de substrat, optionnellement une ou plusieurs couches additionnelles, et au moins une couche d'impression ou un film selon la revendication 6, dans lequel la couche d'impression ou le film est appliqué sur la totalité de la surface ou une partie de la surface de la couche de substrat ou d'une couche additionnelle.

11. Procédé de fabrication d'un document de sécurité et/ou de valeur selon la revendication 10, dans lequel la couche de substrat et/ou la couche additionnelle est réalisé en un matériau de papier ou un matériau polymère organique, dans lequel sur la couche de substrat ou la couche additionnelle une couche d'impression ou un film selon la revendication 6 est appliqué, et dans lequel, le cas échéant, la couche de substrat ou la couche additionnelle, optionnellement ensemble avec une couche de couverture, sont laminées ensemble avant ou après l'application de la couche d'impression ou du film.

12. Procédé de vérification d'un document de sécurité et/ou de valeur selon la revendication 10, dans lequel le document de sécurité et/ou de valeur est soumis à des conditions physiques, qui excitent le semi-conducteur luminescent organique en présence des particules électrocondeucteurs à une émission lumineuse, dans lequel l'émission lumineuse est observée ou mesurée, et dans lequel le document de sécurité et/ou de valeur est classé comme vrai ou contrefait conformément à l'observation ou le mesurage.
